(19) **Europäisches Patentamt**

**European Patent Office**

**Office européen des brevets**

(11) **EP 1 006 661 B1**

(12) **FASCICULE DE BREVET EUROPEEN**

(45) Date de publication et mention
de la délivrance du brevet:
**12.02.2003 Bulletin 2003/07**

(51) Int Cl.⁷: **H03L 7/107**

(21) Numéro de dépôt: **98122443.9**

(22) Date de dépôt: **27.11.1998**

(54) **Générateur de signal à haute fréquence à partir d'une base de temps horlogère**

Hochfrequenztaktgenerator unter Verwendung eines Referenztaktgenerators

High frequency signal generator using a reference clock

(84) Etats contractants désignés:
**CH DE FR GB IT LI NL SE**

(43) Date de publication de la demande:
**07.06.2000 Bulletin 2000/23**

(73) Titulaire: **ASULAB S.A.**
**2074 Marin (CH)**

(72) Inventeur: **Casagrande, Arnaud**
**2523 Lignières (CH)**

(74) Mandataire: **Balsters, Robert et al**
**I C B,**
**Ingénieurs Conseils en Brevets S.A.,**
**7, rue des Sors**
**2074 Marin (CH)**

(56) Documents cités:
**EP-A- 0 595 377**    **US-A- 5 194 828**
**US-A- 5 384 551**    **US-A- 5 428 829**

• **PATENT ABSTRACTS OF JAPAN vol. 005, no.**
**163 (E-078), 20 octobre 1981 (1981-10-20) & JP**
**56 093403 A (SEIKO EPSON CORP), 29 juillet**
**1981 (1981-07-29)**

## Description

La présente invention concerne le domaine technique des générateurs de signal à haute fréquence.

Les générateurs de signal à haute fréquence sont de plus en plus utilisés dans des circuits électriques. Le terme de « synthétiseur » est également employé pour décrire un tel générateur.

Il existe dans l'état de la technique concerné bon nombre de générateurs de signal à haute fréquence. Le document EP 0 595 377 décrit deux types de synthèse d'une haute fréquence : la synthèse dite « directe » et la synthèse dite « indirecte ».

On notera que la présente description ne concerne que les générateurs associés à la synthèse « indirecte ».

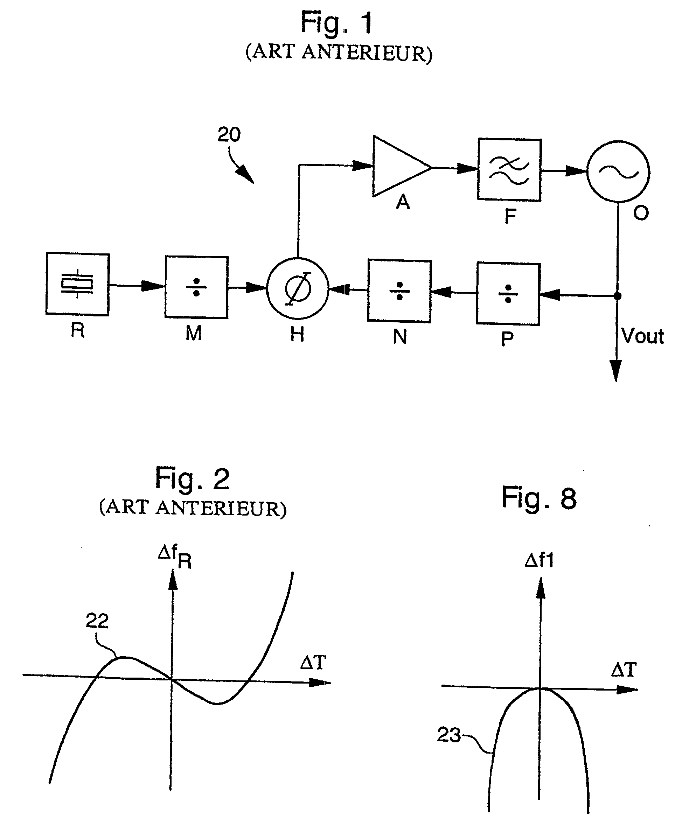

La figure 1 de la présente description représente un générateur de signal à haute fréquence 20 qui met en oeuvre une synthèse « indirecte » telle que décrite dans ce document.

Le générateur 20 comprend, connectés en série, un oscillateur commandé en tension O pouvant fournir un signal Vout ayant une fréquence comprise dans une plage de fréquences prédéterminée, un diviseur préalable P, deux diviseurs programmables N et M, un comparateur de phase et de fréquence H, et un oscillateur de référence R constitué d'un cristal. Le générateur 20 comprend également une boucle d'asservissement à phase asservie connectée entre le comparateur de H et l'oscillateur O, cette boucle d'asservissement comprenant un amplificateur A et un filtre F. La boucle d'asservissement est agencé de sorte que la fréquence du signal Vout est sensiblement constante et égale à une fréquence nominale désirée. On note que les diviseurs N et M sont programmés de manière appropriée de sorte que la fréquence du signal Vout (qui est égale à (R/M)*N*P)) correspond à la fréquence nominale désirée.

Un problème que l'on rencontre-avec un tel générateur est que la fréquence réelle du signal Vout est sensiblement différente de la fréquence nominale, notamment en raison de l'instabilité de l'oscillateur de référence ou encore sous l'influence de la température ambiante. Il en résulte que l'écart entre la fréquence réelle et la fréquence nominale devient supérieure à la précision en fréquence requise pour l'application du générateur, ce qui peut être préjudiciable pour des applications nécessitant une grande précision en fréquence.

A titre illustratif, un tel générateur peut faire partie d'un système de télécommunication utilisant un canal de transmission à bande étroite, par exemple dans des téléphones cellulaires ou des appareils radiofréquences portatifs. Dans ce cas, il est nécessaire de disposer d'un générateur fournissant un signal dont la fréquence porteuse est définie avec une grande précision, de sorte que le transfert des données ait lieu sur une plage de fréquences étroite. Typiquement, dans le cadre d'une telle application, la précision en fréquence du générateur doit être de l'ordre de quelques ppm $(10^{-6})$.

Une solution au problème susmentionné consiste à utiliser un cristal pouvant fournir une basse fréquence extrêmement stable et constante. On utilise communément un cristal de type « AT » dont la précision en fréquence est de l'ordre de 2 à 10 ppm. A titre illustratif, la figure 2 représente une courbe 22 illustrant la dépendance en température de la fréquence porteuse $f_R$ fournie par un tel cristal AT. Comme le représente la figure 2, une variation de température $\Delta T$ provoque sur le cristal AT une variation de fréquence $\Delta f_R$, suivant une fonction de type polynomial d'ordre 3 avec un terme linéaire et un terme cubique. Ainsi, dans une plage de température comprise entre 10 et 50 °C, le cristal AT peut fournir la fréquence $f_R$ sensiblement égale à 15 MHz, avec une précision de l'ordre de 3KHz (ce qui correspond à la précision susmentionnée de 2 à 10 ppm).

Un inconvénient d'utiliser un tel cristal AT est que ce dernier est onéreux et doit être alimenté à des fréquences élevées, ce qui entraîne une consommation de puissance électrique élevée.

Dans le cas où le générateur fait partie d'un système horloger comprenant une base de temps formée par un cristal CT, un inconvénient d'utiliser un cristal AT est que le système horloger ainsi équipé comprend deux cristaux dont la fourniture des signaux à basse fréquence est finalement redondante. Dans ce cas, il serait préférable d'utiliser le cristal CT de la base de temps pour former l'oscillateur de référence du générateur, ce qui permettrait de réduire le nombre de composants du générateur équipant un tel système.

Toutefois, le fait d'utiliser le cristal CT d'un système horloger pour former l'oscillateur de référence d'un générateur de signal à haute fréquence présente l'inconvénient que l'utilisation de la très basse fréquence de ce cristal entraîne un bruit de phase élevé sur le spectre de fréquence du oscillateur commandé en tension.

Un autre inconvénient d'une telle utilisation du cristal CT est que la précision en fréquence de ce cristal est de l'ordre de 60 ppm $(10^{-6})$, ce qui se traduit par le fait que la fréquence varie de 30 KHz sur une plage de températures de 60 °C centrée sur 25 °C, ce qui correspond à une variation dix fois supérieure à la précision précitée d'un cristal AT (2 à 10 ppm). Ceci est préjudiciable dans le cas où le générateur de signal à haute fréquence est utilisé pour transférer des données à un canal de transmission, comme cela a déjà été mentionné ci-dessus.

Dans le domaine des télécommunications, on peut citer en référence le brevet américain US 5,384,551 qui décrit un générateur de signal haute fréquence à capacité de verrouillage rapide et à faible bruit de phase. Ce générateur comprend un premier oscillateur de référence fournissant un signal de référence, et un deuxième oscillateur commandé en tension fournissant le signal haute fréquence. Ce générateur comprend également un comparateur de phase et de fréquence pour comparer le signal de référence et un signal provenant d'un diviseur de fréquence du signal haute fréquence. Le comparateur fournit, dans une boucle d'asservissement, deux signaux de commande à un filtre afin que ce dernier fournisse une tension de commande à l'oscillateur commandé en tension. Dans la boucle d'asservissement, un moyen de fourniture d'indicateur reçoit un indicateur du comparateur fonction de la différence de phase entre les deux signaux comparés. Si la différence de phase entre les deux signaux est plus grande qu'une valeur seuil déterminée un circuit complémentaire au filtre est enclenché pour permettre un verrouillage rapide de la boucle d'asservissement.

Un inconvénient d'un tel générateur est qu'il ne peut pas équiper un système horloger, car l'oscillateur de référence, comprenant notamment un cristal, fournit un signal de référence à haute fréquence supérieure au MHz, ce qui est un inconvénient. De ce fait, aussi bien le comparateur que le filtre fonctionne à haute fréquence et ne permet pas de réduire la puissance consommée.

Un but de la présente invention est de prévoir un générateur de signal à haute fréquence destiné à équiper un système horloger comprenant une base de temps formée par un cristal de type CT, ce générateur palliant les inconvénients susmentionnés, notamment un tel générateur pouvant fournir un signal avec une précision en fréquence inférieure à 30 Khz.

Un autre but de la présente invention est de prévoir un générateur de signal à haute fréquence comprenant un oscillateur commandé en tension et une boucle pouvant fournir un signal avec une précision en fréquence inférieure à 30 Khz.

Un autre but de la présente invention est de prévoir un générateur de signal à haute fréquence comprenant un oscillateur commandé en tension et une boucle d'asservissement à phase asservie, l'agencement de ce générateur permettant un verrouillage rapide de la boucle d'asservissement sur la fréquence nominale.

Un autre but de la présente invention est de prévoir un tel générateur palliant l'inconvénient que l'utilisation de la très basse fréquence du cristal CT entraîne un bruit de phase élevé sur le spectre de fréquence de l'oscillateur commandé en tension.

Un autre but de la présente invention est de prévoir un générateur de signal à haute fréquence pouvant fournir un signal à haute fréquence, cette fourniture étant indépendante de la température.

Un autre but de la présente invention est de prévoir un tel générateur pouvant fournir un signal avec une précision en fréquence inférieure à 4 KHz.

Un autre but de la présente invention est de prévoir un générateur de signal à haute fréquence répondant aux préoccupations industrielles habituelles d'encombrement et de coût.

Ces buts ainsi que d'autres sont atteints par le générateur de signal à haute fréquence selon la revendication 1.

L'invention a ainsi pour objet un tel générateur caractérisé en ce que le cristal de référence est formé à partir du cristal du système horloger, ce qui a pour avantage d'éviter l'utilisation onéreuse d'un cristal de type AT adapté à la synthèse de la deuxième fréquence.

Un autre avantage de former le cristal de référence à partir du cristal horloger est d'éviter la fourniture redondante de deux signaux à basse fréquence dans un système horloger, l'un étant fourni par la base de temps, et l'autre étant fourni par le premier oscillateur, ce qui répond aux préoccupation habituelles en industrie de coût, d'encombrement et de rationalisation.

Un autre avantage de former le cristal de référence à partir du cristal horloger est de réduire le nombre de composants du générateur et par conséquent la consommation de puissance électrique, ce qui répond au souci constant en industrie de diminuer la consommation de puissance électrique.

Le générateur est également caractérisé en ce que le filtre est agencé pour recevoir un indicateur d'état de boucle d'asservissement et, en réponse, être agencé pour avoir la configuration d'un filtre à bande passante étroite (respectivement large), quand la boucle d'asservissement est (respectivement n'est pas) verrouillée. Un avantage d'un tel agencement est de permettre un verrouillage rapide de la boucle d'asservissement sur la fréquence nominale. En effet, on rappelle que plus la bande passante du filtre est large (respectivement étroite), plus le temps de verrouillage de la boucle d'asservissement est court (respectivement long).

Un autre avantage d'un tel agencement est que l'utilisation de la très basse fréquence du cristal horloger n'entraîne pas un bruit de phase sur le spectre de fréquence du deuxième oscillateur. En effet, on note que la largeur de bande du filtre a un effet sur la pureté spectrale du deuxième oscillateur, puisque le bruit de phase du cristal horloger est amplifié sur la deuxième fréquence. Par contre, quand la bande passante du filtre est étroite, la reproduction du bruit sur la fréquence porteuse est réduite.

Selon une autre caractéristique de la présente invention, le générateur comprend en outre un dispositif de compensation thermique comprenant : un capteur de température disposé à proximité du cristal de référence pour fournir une valeur de mesure de la température ; et une première mémoire pouvant contenir une table de correspondance entre des valeurs de température et des valeurs de premier facteur de division, recevoir la valeur de mesure et, en réponse, fournir au premier diviseur la valeur de premier facteur de division qui, d'après la table de correspondance, correspond à la valeur de température la plus proche de la valeur de mesure. Un avantage d'un tel dispositif de compensation thermique est que la fourniture de la deuxième fréquence est indépendante de la température.

En effet, une variation de 1 sur le facteur de division N, se traduit par une variation de 4 KHz (c'est-à-dire la fréquence f4 fournie au comparateur) lors de la comparaison de la fréquence f3.

Selon une autre caractéristique de la présente invention, le comparateur, le filtre, le deuxième oscillateur, le premier diviseur et le moyen de fourniture d'indicateur sont réalisés de façon monolithique dans un substrat semi-conducteur. Un avantage d'une telle réalisation est que le générateur peut être formé par une filière de fabrication communément utilisée dans l'industrie des semi-conducteurs.

Ces buts, caractéristiques et avantages, ainsi que d'autres, de la présente invention apparaîtront plus clairement à la lecture de la description détaillée de deux modes de réalisation préférés de l'invention, donné à titre d'exemple uniquement, en relation avec les figures jointes, parmi lesquelles :

- la figure 1 déjà citée représente un générateur de signal à haute fréquence classique ;
- la figure 2 déjà citée représente une courbe illustrant la relation entre une température et une variation de fréquence, associée à un cristal AT ;
- la figure 3 représente un premier mode de réalisation préféré d'un générateur d'un signal à haute fréquence selon la présente invention;
- la figure 4 représente de façon détaillée un filtre du générateur de la figure 3;
- la figure 5 représente de façon détaillée un moyen de commande du filtre de la figure 4;
- la figure 6 représente une courbe illustrant la relation entre une valeur efficace de courant et une différence de fréquence;
- la figure 7 représente un deuxième mode de réalisation préféré d'un générateur de signal à haute fréquence selon la présente invention;
- la figure 8 représente une courbe illustrant la relation entre une température et une variation de fréquence, associée à un cristal CT;
- la figure 9 représente quatre chronogrammes associés au fonctionnement du générateur de la figure 3; et
- la figure 10 représente cinq chronogrammes associés au fonctionnement du générateur de la figure 7.

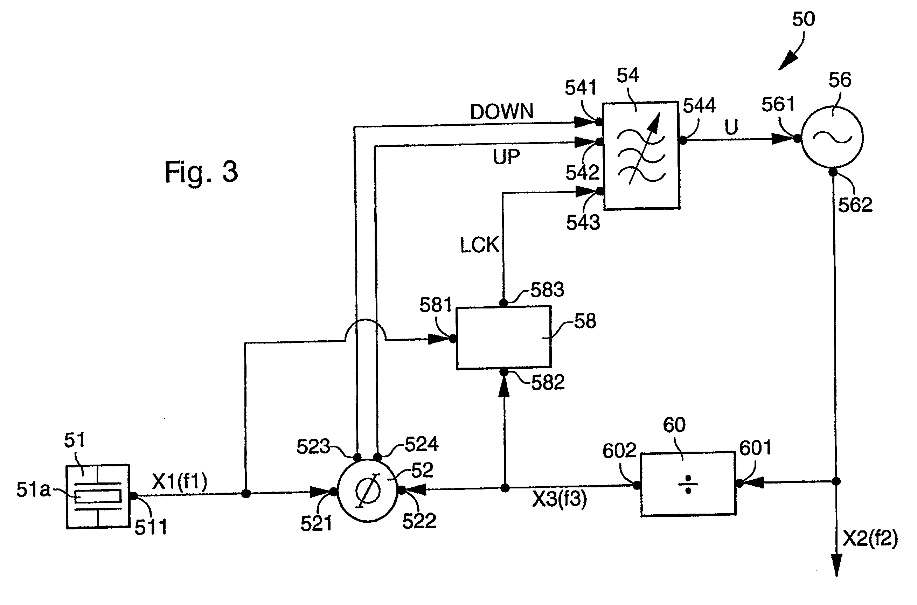

La figure 3 représente un premier mode de réalisation préféré d'un générateur de signal à haute fréquence selon la présente invention, ce générateur étant désigné par la référence 50.

Le générateur 50 est destiné à équiper un système horloger (non représenté en figure 3) comprenant un cristal 51a utilisé comme base de temps, ce cristal pouvant fournir un signal X1 à une basse fréquence f1. Typiquement, on réalise de préférence le cristal 51a en utilisant un cristal de type CT propre à fournir une fréquence porteuse (c'est-à-dire la fréquence f1) égale à 32768 Hz, un tel cristal étant appelé communément dans le domaine de l'horlogerie « cristal horloger ».

Le générateur 50 est agencé pour fournir, à partir du signal X1, un signal X2 à une fréquence f2 élevée et sensiblement égale à une fréquence nominale f0 prédéterminée (par exemple 434 Mhz). Dans la suite de la description, on notera que l'expression « sensiblement égale » est liée à deux notions distinctes : la précision en fréquence et la résolution. A titre d'exemple, la précision en fréquence (désignée $\frac{\Delta f}{f}$) du générateur 50 est choisie égale à 0,25 ppm. Ainsi, la fréquence f2 est comprise entre f0 $(1-\frac{\Delta f}{f})$ et f0 $(1+\frac{\Delta f}{f})$, ce qui définit une plage de fréquence dans laquelle la fréquence f2 est dite « sensiblement égale » à la fréquence nominale f0. La résolution du générateur 50 sera décrite ci-après.

Comme le représente la figure 3, le générateur 50 comprend, connectés en série : un oscillateur commandé en tension, ou deuxième oscillateur 56, pouvant fournir le signal X2 ayant la fréquence f2 comprise dans la plage de fréquences prédéterminée, un diviseur préalable 60, un comparateur de fréquence 52, et un oscillateur de référence, ou premier oscillateur 51. Le générateur 50 comprend également une boucle d'asservissement à phase asservie connectée entre le comparateur 52 et l'oscillateur 56, cette boucle d'asservissement comprenant un filtre 54 et un moyen de fourniture d'état de boucle d'asservissement 58.

L'oscillateur 56 est agencé pour recevoir une tension de commande U fournie par le filtre 54 et, en réponse, fournir le signal X2 à la fréquence f2, cette dernière étant variable et dépendant: de la tension de commande U, comme cela est décrit ci-après. A cet effet, l'oscillateur 56 comprend une borne de commande 561, pour recevoir la tension de commande U, et une borne de sortie 562, pour fournir le signal X2 à la fréquence f2.

De préférence, on réalise l'oscillateur 56 en utilisant un oscillateur commandé en tension appelé communément « VCO » (acronyme provenant de l'anglais « Voltage Controlled Oscillator ») tel que celui vendu dans le commerce par Murata sous la référence MQE744-430. On rappelle que la fréquence d'un signal fourni par un tel oscillateur est commandée par une tension continue variable, appliquée à un élément faisant varier la fréquence de résonance du circuit oscillant de l'oscillateur en agissant comme un condensateur variable à réglage instantané (comportement localement linéaire de l'oscillateur VCO). On notera en figure 3 que cette tension continue variable correspond à la tension de commande U.

Le diviseur 60 est agencé pour fournir un signal X3 à une basse fréquence f3, de sorte que la fréquence f3 est égale à la fréquence f2 divisée par un facteur de division N prédéterminé. A cet effet, le diviseur 60 comprend une borne d'entrée 601 connectée à la borne 562 de l'oscillateur 56, pour recevoir le signal X2, et une borne de sortie 602 connectée au comparateur 52, pour fournir le signal X3.

Typiquement, on réalise de préférence le diviseur 60 en formant un prédiviseur à deux modules fonctionnant à très haute fréquence, ce prédiviseur étant connu en soi. On note que la valeur nominale N0 du facteur de division N est fixée par les fréquences f0 et f1, et est constante à une température To donnée (par exemple 25 °C). A titre d'exemple, dans le cas où les fréquences f1 et f0 sont égales respectivement à 32 KHz et à 434 MHz, la valeur N0 est de l'ordre de 13562.

Le comparateur 52 est agencé pour comparer la fréquence f3 à la fréquence f1 et, en réponse à cette comparaison, fournir deux signaux de commande DOWN et UP. Le comparateur 52 peut ainsi être agencé de sorte que, quand la fréquence f3 est sensiblement supérieure à la fréquence f1, les signaux DOWN et UP sont égaux respectivement à un niveau haut « 1 » et à un niveau bas « 0 » et que, quand la fréquence f3 est sensiblement inférieure à la fréquence f1, les signaux DOWN et UP sont égaux respectivement au niveau « 0 » et au niveau « 1 » (les expressions « sensiblement inférieure » et « sensiblement supérieure » étant définies ci-après). A cet effet, le comparateur 52 comprend une borne d'entrée 521 connectée à l'oscillateur de référence 51, pour recevoir le signal X1, et une deuxième borne d'entrée 522 connectée à la borne 602 du diviseur 60, pour recevoir le signal X3. Le comparateur 52 comprend en outre deux bornes de sortie 523 et 524, pour fournir respectivement les signaux de commande DOWN et UP.

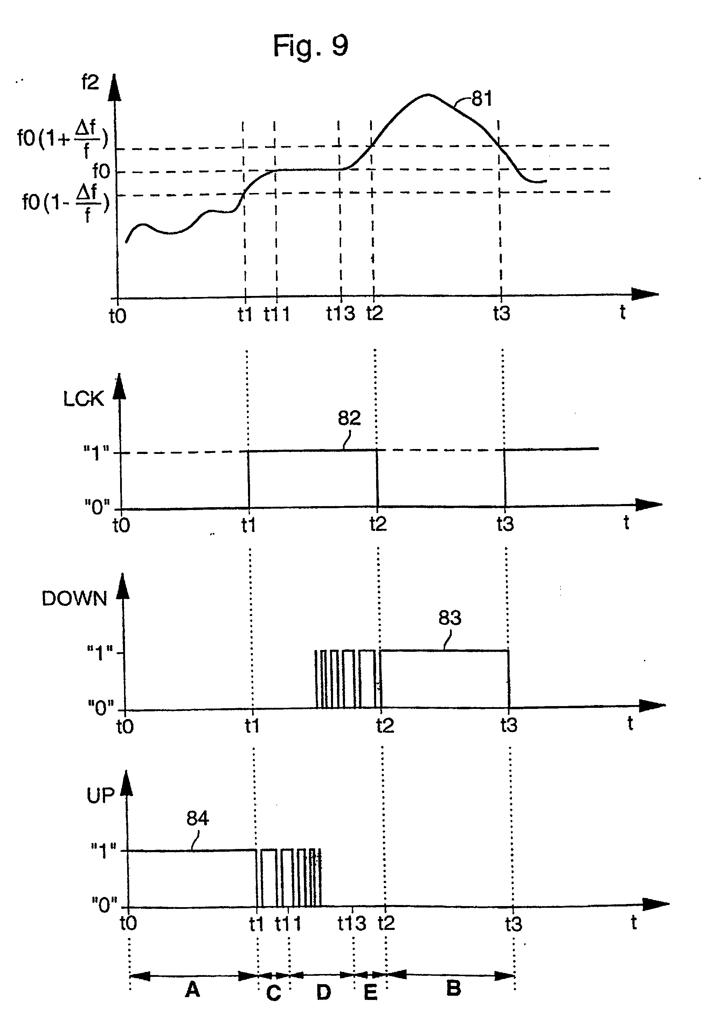

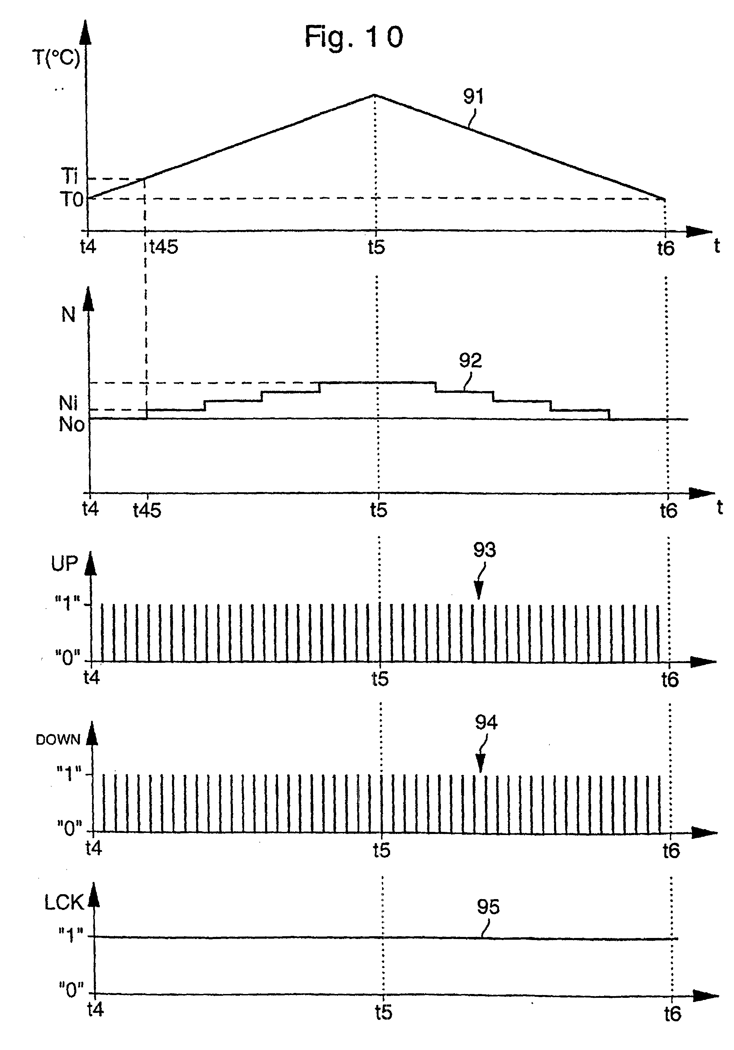

On notera (notamment aux figures 9 et 10) que les signaux DOWN et UP ne sont pas égaux simultanément au niveau « 0 », et comprennent alors des pointes de conversion (appelées en anglais « glitch ») propres à provoquer un bruit de phase.

De préférence, on réalise le comparateur 52 en utilisant un comparateur de phase et de fréquence connu dans le domaine technique concerné, et décrit notamment dans l'ouvrage « Modern Communication Circuits » de J. Smith, Editions Mac Graw-Hill, ISBN 0-07-066-544-3, p.308.

L'oscillateur de référence 51 est agencé pour comprendre le cristal 51a du système horloger, de manière à fournir le signal X1 à la fréquence f1. A cet effet, l'oscillateur de référence 51 comprend une borne d'alimentation (non représentée en figure 3) pour fournir une alimentation électrique au cristal 51a, et une borne de sortie 511 connectée à la borne 521 du comparateur 52, pour fournir le signal X1.

De préférence, la réalisation de l'oscillateur de référence 51 à partir du cristal 51a est connue en soi, et décrite notamment dans les documents CH 640.693 et CH 631.047.

L'homme du métier note qu'une variation de 1 sur le facteur de division N se traduit par une variation de 32 KHz (ce qui correspond à la valeur de la fréquence f1 fournie comme consigne au comparateur 52) lors de la comparaison de la fréquence f3, ce qui définit la résolution du générateur 50.

Le moyen de fourniture d'indicateur 58 est agencé pour fournir un indicateur (désigné LCK) contenant l'état de la boucle d'asservissement. En effet, cette boucle d'asservissement peut avoir deux états distincts.

Un état dit « de verrouillage » correspond au fait que la haute fréquence f2 est « sensiblement égale » à la fréquence nominale f0 (ce qui est équivalent au fait que la fréquence f3 est « sensiblement égale » à la fréquence f1). Et un état dit de « non-verrouillage » correspond au fait que la haute fréquence f2 n'est pas « sensiblement égale » à la fréquence nominale f0 (ce qui est équivalent au fait que la fréquence f3 n'est pas « sensiblement égale » à la fréquence f1).

Comme le représente la figure 3, le moyen de fourniture d'indicateur 58 est agencé pour recevoir les signaux X1 et X3 et, en réponse, fournir l'indicateur LCK de sorte que, quand la différence de fréquence f3-f1 est inférieure (respectivement supérieure) à la valeur $f1 * \frac{\Delta f}{f}$, l'indicateur LCK vaut « 1 » (respectivement « 0 »). A cet effet, le moyen de fourniture d'indicateur 58 comprend deux bornes d'entrée 581 et 582 connectées respectivement à la borne de sortie 511 de l'oscillateur de référence 51 et à la borne 602 du diviseur 60, pour recevoir respectivement les signaux X1 et X3, et une borne de sortie 583 connectée au filtre 54, pour fournir l'indicateur LCK.

On note que la fréquence f3 est comprise entre $f1(1-\frac{\Delta f}{f})$ et $f1(1+\frac{\Delta f}{f})$, ce qui définit une plage de fréquence dans laquelle la fréquence f3 est dite « sensiblement égale » à la fréquence de consigne f1. Autrement dit, l'expression « sensiblement égale » a le même sens aux basses fréquences qu'aux hautes fréquences.

On note que le comparateur de fréquence 52, le diviseur 60 et le moyen de fourniture d'indicateur 58 peuvent être formés par un composant vendu dans le commerce par Fujitsu sous la référence MB15A16.

Le filtre 54 est agencé pour recevoir l'indicateur LCK et les signaux de commande DOWN et UP, convertir ces signaux et, en réponse, fournir la tension de commande U continue, de sorte que le filtre 54 a une bande passante étroite (respectivement large), quand la boucle d'asservissement est (respectivement n'est pas) verrouillée. Dans le cas présent, la bande passante du filtre 54 est étroite (respectivement large), quand l'indicateur LCK vaut « 1 » (respectivement « 0 »). A cet effet, le filtre 54 comprend deux bornes d'entrée 541 et 542 connectées respectivement aux bornes 523 et 524 du comparateur 52, pour recevoir respectivement les signaux DOWN et UP, et une borne d'entrée 543 connectée au moyen de fourniture d'indicateur 58, pour recevoir l'indicateur LCK. Le filtre 54 comprend également une borne de sortie 544 connectée à la borne 561 de l'oscillateur 56, pour fournir la tension de commande U.

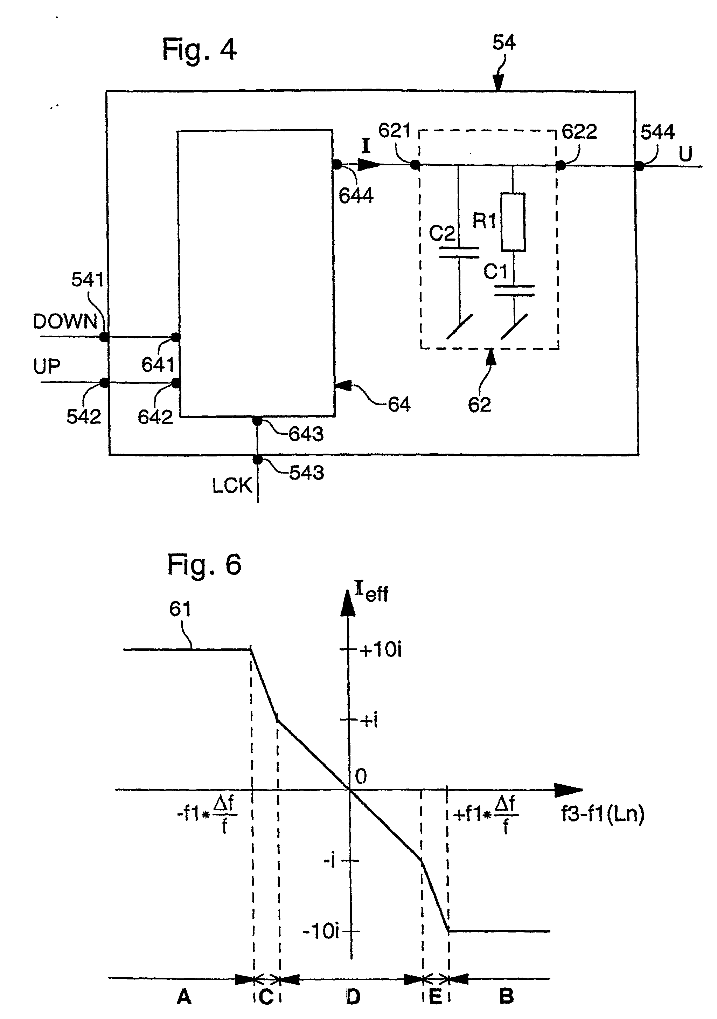

On va décrire maintenant de façon détaillée le filtre 54, à l'aide des figures 4 à 6. On note que des éléments du filtre 54 décrits en relation avec la figure 3 ont été désignés par les mêmes références.

Comme le représente la figure 4, le filtre 54 comprend un filtre passe-bas 62 et un moyen de commande 64 pouvant fournir un courant de commande I, de sorte que la fréquence de coupure du filtre passe-bas 62 dépend du courant de commande I.

Le moyen de commande 64 est agencé pour recevoir l'indication LCK et les signaux de commande DOWN et UP et, en réponse, fournir le courant de commande I. A cet effet, le moyen de commande 64 comprend trois bornes d'entrée 641 à 643 connectées respectivement aux bornes 541 à 543 du filtre 54, pour recevoir respectivement les signaux de commande DOWN et UP et l'indicateur LCK, et une borne de sortie 644 connectée au filtre passe-bas 62, pour fournir le courant de commande I.

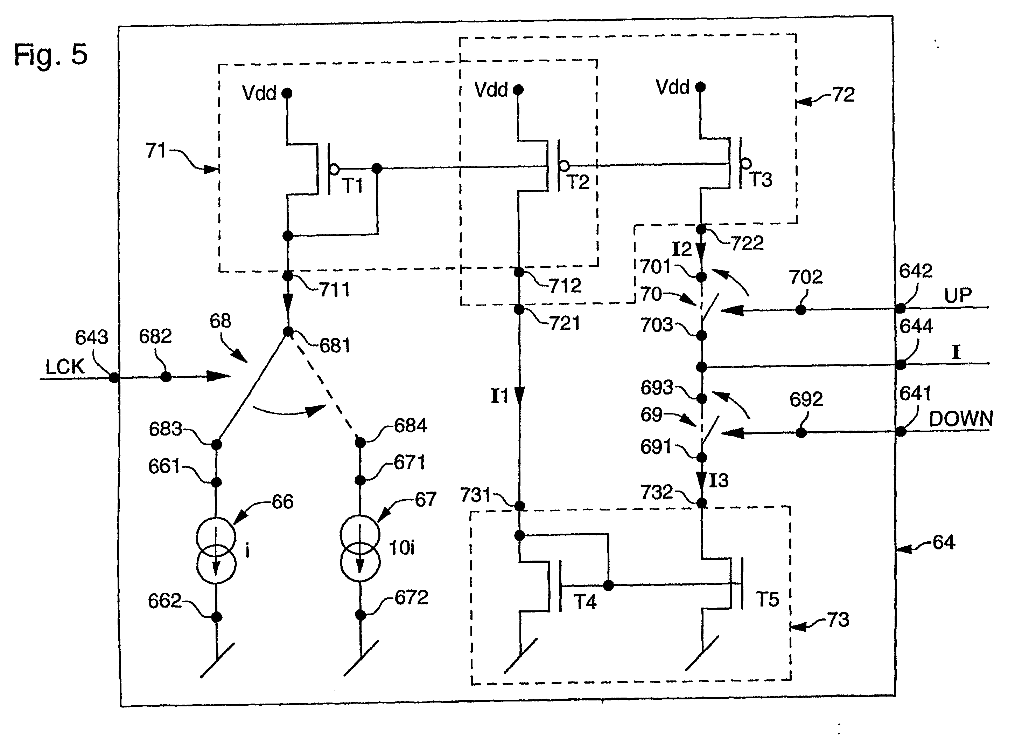

Comme le représente de façon plus détaillée la figure 5, le moyen de commande 64 comprend deux sources de courant 66 et 67, trois commutateurs 68 à 70, et trois miroirs de courant 71 à 73.

La source de courant 66 est agencée pour fournir un courant i. A cet effet, la source de courant 66 comprend une borne de fourniture 661 connectée au commutateur 68, pour fournir le courant i, et une borne de masse 662 connectée à la masse du système. La source de courant 67 est agencée pour fournir un courant 10i. A cet effet, la source de courant 67 comprend une borne de fourniture 671 connectée au commutateur 68, pour fournir le courant 10i, et une borne de masse 672 connectée à la masse du système. Typiquement, on réalise de préférence chacune des sources de courant 66 et 67 à partir d'une source de référence classique insensible à la température.

Le commutateur 68 comprend une borne d'entrée 681 connectée au miroir de courant 71, une borne de commande 682 connectée à la borne 643 du moyen de commande 64, pour recevoir l'indicateur LCK, et deux bornes de sortie 683 et 684 connectées respectivement à la borne 661 de la source 66 et à la borne 671 de la source 67. Le commutateur 68 est agencé pour connecter la borne 681 à la borne 683 (respectivement à la borne 684), quand l'indicateur LCK vaut « 1 » (respectivement « 0 »). Typiquement, on réalise de préférence le commutateur 68 à partir de deux transistors commandés en opposition de phase.

Le miroir de courant 71 comprend une borne d'entrée 711 connectée à la borne 681 du commutateur 68, pour fournir le courant i (respectivement le courant 10i), et une borne de sortie 712, pour fournir un courant I1. Le miroir de courant 71 est agencé de sorte que le courant I1 est une copie du courant i (respectivement du courant 10i). Typiquement, on réalise de préférence le miroir de courant 71 à partir de deux transistors T1 et T2 de type MOS et à canal de type P, l'agencement de ces transistors étant supposé connu en soi.

Le miroir de courant 72 comprend une borne 721 connectée à la borne 712 du miroir de courant 71, pour fournir le courant I1, et une borne de sortie 722, pour fournir un courant I2. Le miroir de courant 72 est agencé de sorte que le courant I2 est une copie du courant I1. Typiquement, on réalise de préférence le miroir de courant 72 à partir du transistor T2 et d'un transistor T3 de type MOS et à canal de type P, l'agencement de ces transistors étant supposé connu en soi.

Le miroir de courant 73 comprend une borne 731 connectée à la borne 712 du miroir de courant 71, pour recevoir le courant I1, et une borne de sortie 732, pour recevoir un courant I3. Le miroir de courant 73 est agencé de sorte que le courant I3 est une copie du courant I1. Typiquement, on réalise de préférence le miroir de courant 73 à partir de deux transistors T4 et T5 de type MOS et à canal de type N, l'agencement de ces transistors étant supposé connu en soi.

Le commutateur 69 comprend une borne d'entrée 691 connectée à la borne 732 du miroir de courant 73, pour recevoir le signal I3, une borne de commande 692 connectée à la borne 641 du moyen de commande 64, pour recevoir le signal de commande DOWN, et une borne de sortie 693 connectée à la borne 644 du moyen de commande 64, pour pouvoir fournir le courant I. Le commutateur 69 est agencé pour connecter (respectivement ne pas connecter) la borne 691 à la borne 693, quand le signal de commande DOWN vaut « 1 » (respectivement « 0 »). Typiquement, on réalise de préférence le commutateur 69 à partir d'un transistor de type MOS et à canal N.

Le commutateur 70 comprend une borne d'entrée 701 connectée à la borne 722 du miroir de courant 72, pour recevoir le signal I2, une borne de commande 702 connectée à la borne 642 du moyen de commande 64, pour recevoir le signal de commande UP, et une borne de sortie 703 connectée à la borne 644 du moyen de commande 64, pour pouvoir recevoir le courant I. Le commutateur 70 est agencé pour connecter (respectivement ne pas connecter) la borne 701 à la borne 703, quand le signal de commande UP vaut « 1 » (respectivement « 0 »). Typiquement, on réalise de préférence le commutateur 70 à partir d'un transistor de type MOS et à canal P.

On note que le courant de commande I correspond à un flux de courant dont l'amplitude (« 10i » ou « i ») dépend de la valeur de l'indicateur LCK, et dont le sens d'écoulement dépend des valeurs des signaux de commande DOWN et UP (les signes « + » et « - » représentant une injection du courant I du moyen 64 vers le filtre 62, et du filtre 62 vers le moyen 64, respectivement). On note également que le courant de commande I provoque la fourniture de la tension de commande U sous la forme d'une tension continue et sans bruit de phase.

Le filtre passe-bas 62 est agencé pour recevoir le courant de commande I, avoir une fréquence de coupure représentative du courant de commande I et, en réponse, fournir la tension de commande U. A cet effet, le filtre passe-bas 62 comprend une borne 621 connectée au moyen de commande 64, pour recevoir le courant de commande I, et une borne 622 connectée à la borne de sortie 544 du filtre 54, pour fournir la tension U.

Typiquement, on réalise de préférence le filtre passe-bas 62 à partir de deux condensateurs C1 et C2 et d'une résistance R1. Comme le représente la figure 4, le condensateur C2 est connecté entre la borne 621 et la masse du système, et le condensateur C1 est connecté en série avec la résistance R1 entre la borne 621 et la masse du système.

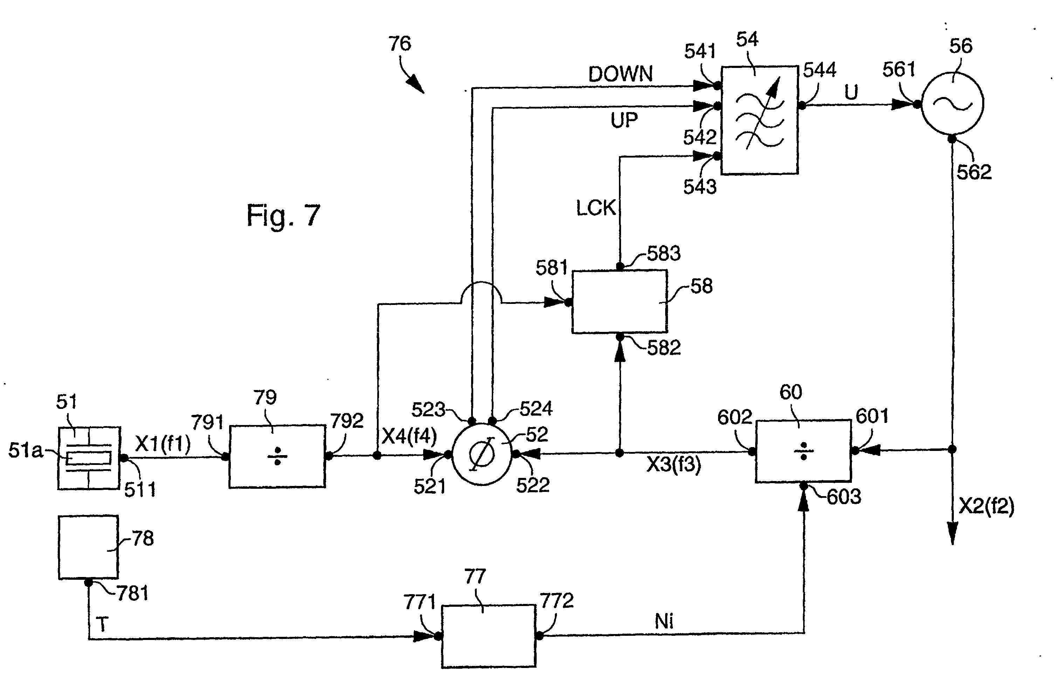

On va maintenant décrire brièvement le fonctionnement du filtre 54, en combinaison avec le comparateur 52, à l'aide de la figure 6 qui représente une courbe 61 illustrant la relation entre la valeur efficace Ieff du courant de commande I, et la différence de fréquence f3-f1. On note que la courbe 61 est représentée en échelle logarithmique, et qu'elle comprend cinq segments correspondants à cinq plages de fréquence « A » à « E» décrites ci-après.

Quand la différence de fréquence f3-f1 est inférieure à -f1$*\frac{\Delta f}{f}$ (plage « A »), la valeur Ieff vaut +10i. De même, quand la différence de fréquence f3-f1 est supérieure à +f1$*\frac{\Delta f}{f}$ (plage « B »), la valeur Ieff vaut -10i. On note que les plages « A » et « B » correspondent au cas où la boucle d'asservissement n'est pas verrouillée.

Quand la différence de fréquence f3-f1 est comprise entre -f1$*\frac{\Delta f}{f}$ et +f1$*\frac{\Delta f}{f}$, la valeur Ieff passe continûment de +10i à -10i. On note que le comparateur 52 fournit principalement une comparaison en fréquence sur les plage « C » et « E », et une comparaison en phase sur la plage « D », ce qui se traduit respectivement par une pente forte et une pente faible. On note également que les plages « C » à « E » correspondent au cas où la fréquence f3 est « sensiblement égale » à la fréquence f1, c'est-à-dire au cas où la boucle d'asservissement est verrouillée.

A titre de perfectionnement, on peut équiper d'un dispositif de compensation thermique le générateur de signal à haute fréquence selon la présente invention.

En effet, on rappelle que la fréquence réelle f1 délivrée par le cristal 51a de l'oscillateur de référence 51 change dans le temps et également sous l'influence des variations de la température ambiante. Par exemple, pour un oscillateur horloger dont le cristal vibre à sa fréquence nominale à une température To de 25 °C, l'erreur de cette fréquence peut atteindre 60 ppm dans une plage de température de -10 à +50 °C.

Pour la compensation thermique d'une base de temps telle que celle du système horloger équipé du générateur selon la présente invention, plusieurs circuits de compensation ont été proposés dans l'état de la technique concerné, notamment dans le brevet US 4.761.771 ou le brevet CH 650.122.

On va maintenant décrire un deuxième mode de réalisation préféré d'un générateur selon la présente invention, à l'aide de la figure 7 qui représente un générateur 76 pouvant réaliser une compensation thermique de la fréquence f2 fournie par l'oscillateur 56. Les objets du générateur 76 identiques à ceux du générateur 50 de la figure 3 ont été désignés par les mêmes références.

Comme le représente la figure 7, le générateur 76 comprend en outre une mémoire 77 et un capteur de température 78.

Le capteur 78 est agencé pour mesurer la température ambiante (c'est-à-dire celle du cristal 51a et des différents composants du générateur 76) et fournir une valeur de mesure T de cette température. A cet effet, le capteur 78 est disposé à proximité du cristal 51a, et comprend une borne de sortie 781 connectée à la mémoire 77, pour fournir la valeur de mesure T.

Typiquement, on réalise de préférence le capteur de température en utilisant une résistance dite « NTC » (acronyme provenant de l'anglais « Negative Temperature Coefficient »).

La mémoire 77 est agencée pour contenir une table de correspondance entre des premières valeurs Ti de la température ambiante et des valeurs Ni du facteur de division N. A cet effet, la mémoire 77 comprend une borne d'entrée 771 connectée à la borne 781 du capteur 78, pour recevoir la valeur de mesure T, et une borne de sortie 772 connectée à une borne de commande 603 du diviseur 60, pour fournir à ce dernier la valeur Ni correspondant à la valeur Ti qui est la plus proche de la valeur de mesure T, d'après la table de correspondance.

Typiquement, on réalise de préférence la mémoire 77 en utilisant une mémoire de type EEPROM connu en soi. La table de correspondance est adaptée pour l'asservissement sur la fréquence f0 égale à 434 Mhz, et est supposée connue à partir d'une calibration du cristal 51a. Une telle calibration consiste à déterminer, à partir de mesures réalisées à trois valeurs de température différentes, les coefficients paramétriques d'une parabole propre au cristal 51a. A titre illustratif, la figure 8 représente une courbe 23 illustrant la dépendance en température de la fréquence f1 fournie par le cristal 51a. Comme le représente la figure 8, une variation de température $\Delta T$ provoque sur le cristal CT une variation de fréquence $\Delta f1$, suivant une fonction de type quadratique. On note que la courbe 23 permet de déterminer les valeur de fréquence f1i du cristal 51a correspondant aux valeurs Ti, et que les valeurs Ni contenues dans la table de correspondance sont égales à (N0*f1/f1i).

L'homme du métier note qu'une telle caractérisation du cristal 51a permet de fournir une calibration en température et en fréquence de ce cristal, c'est-à-dire de déterminer la position du sommet de la courbe parabolique 23. En effet, la position de ce sommet peut varier entre deux cristaux de même type, de sorte que la précision en fréquence correspondante est comprise entre 0 et 60 ppm. Ainsi, le générateur 76 qui réalise une compensation thermique réalise également une calibration en fréquence.

A titre de perfectionnement, comme le représente la figure 7, le générateur 76 peut comprendre un diviseur 79 connecté entre l'oscillateur de référence 51 et le comparateur 52, et agencé pour fournir à ce dernier un signal X4 à une fréquence f4 (par exemple 4 KHz) qui soit égale à la fréquence f1 (c'est-à-dire 32 KHz) divisée par un facteur de division N2 (par exemple 8). A cet effet, le diviseur 79 comprend une borne d'entrée 791 connectée à la borne 511 de l'oscillateur de référence 51, et une borne de sortie 792 connectée à la borne 521 du comparateur 52. Typiquement, on réalise de préférence le diviseur 79 en utilisant un circuit diviseur connu en soi.

L'homme du métier note qu'un avantage de l'agencement du diviseur 59 est de fournir la fréquence f4 (c'est-à-dire une valeur de consigne inférieure à la fréquence f1), ce qui confère au générateur 76 une résolution améliorée. En effet, une variation de 1 sur le facteur de division N se traduit par une variation de 4 KHz (c'est-à-dire la fréquence f4 fournie au comparateur 52) lors de la comparaison de la fréquence f3.

On va maintenant décrire le fonctionnement du générateur 50 à l'aide de la figure 9 qui représente quatre chronogrammes 81 à 84, ainsi que le fonctionnement du générateur 76 à l'aide de la figure 10 qui représente cinq chronogrammes 91 à 95.

On notera que la figure 9 illustre l'asservissement de la fréquence f2 à la fréquence nominale f0, sans tenir compte d'une variation de température, tandis que la figure 10 illustre l'asservissement de la fréquence f2 à la fréquence nominale f0, suite à une variation de température.

En se référant à la figure 9, on note que les chronogrammes 81 à 84 sont associés respectivement à la fréquence f2 et aux signaux LCK, DOWN et UP.

Considérons l'intervalle de temps compris entre un instant initial t0 et un instant t1, durant lequel la fréquence f2 est inférieure à $f0^*(1-\frac{\Delta f}{f})$. Il en résulte que la fréquence f3 est inférieure à $f1^*(1-\frac{\Delta f}{f})$. Autrement dit, la boucle d'asservissement n'est pas verrouillée et cette situation correspond au cas « A » de la figure 6. Ainsi, l'indicateur LCK vaut « 0 », le signal de commande DOWN vaut « 0 » et le signal de commande UP vaut « 1 ». Il s'ensuit que la valeur Ieff vaut +10i, et que la fréquence f2 fournie par l'oscillateur de référence 51 tend à croître vers la fréquence nominale f0.

Considérons l'intervalle de temps compris entre l'instant t1 et un instant t2, durant lequel la fréquence f2 est supérieure à $f0^*(1-\frac{\Delta f}{f})$, mais inférieure à $f0^*(1+\frac{\Delta f}{f})$. Il en résulte que la fréquence f3 est supérieure à $f1^*(1-\frac{\Delta f}{f})$, mais inférieure à $f1^*(1+\frac{\Delta f}{f})$. Autrement dit, la boucle d'asservissement est verrouillée, et cette situation correspond aux cas « C » à « E » de la figure 6 (on note que l'intervalle de temps compris entre des instants t11 et t13 correspond au cas « D » de la figure 6). Ainsi, l'indicateur LCK vaut « 1 », le signal de commande DOWN vaut « 0 » et le signal de commande UP vaut « 1 ». Il s'ensuit que la fréquence f2 est sensiblement égale à la fréquence nominale f0.

Considérons l'intervalle de temps compris entre l'instant t2 et un instant t3, durant lequel la fréquence f2 est supérieure à $f0^*(1+\frac{\Delta f}{f})$. Il en résulte que la fréquence f3 est supérieure à $f1^*(1+\frac{\Delta f}{f})$. Autrement dit, la boucle d'asservissement n'est pas verrouillée, et cette situation correspond au cas « B » de la figure 6. Ainsi, l'indicateur LCK vaut « 0 », le signal de commande DOWN vaut « 1 » et le signal de commande UP vaut « 0 ». Il s'ensuit que la valeur Ieff est égale à +10i, et que la fréquence f2 fournie par l'oscillateur de référence 51 tend à décroître vers la fréquence nominale f0.

En se référant à la figure 10, on note que les chronogrammes 91 à 95 sont associés respectivement à la température ambiante T, au facteur de division N et aux signaux UP, DOWN et LCK. On supposera, dans la suite de la description, que la boucle d'asservissement est verrouillée, c'est-à-dire que l'état de verrouillage est maintenu par le générateur 76. Ainsi, les signaux UP et DOWN valent « 0 » (et comprennent des pointes de conversion), et l'indicateur LCK vaut « 1 ».

Considérons un instant initial t4 où la température T est égale à 25 °C. D'après l'hypothèse, à l'instant t4, la fréquence f2 est sensiblement égale à la fréquence nominale f0, et le facteur de division N est égale à la valeur nominale N0. Autrement dit, les valeurs f1, N0 et f0 sont liées par la relation : N0*f1 = f0.

Supposons que, à partir de l'instant t4, la température T commence à augmenter et atteint à un instant t45 la valeur Ti. Il s'ensuit, d'après la courbe 23 de la figure 8, que la fréquence f1 fournie par le cristal 51a commence à diminuer, c'est-à-dire est égale à une valeur f1i inférieure à la fréquence f1 (mais supérieure à $f1^*(1-\frac{\Delta f}{f})$ selon l'hypothèse). Il s'ensuit également que le capteur 78 fournit à la mémoire 77 la valeur de température Ti. En réponse, la mémoire 77 fournit au diviseur 60 la valeur Ni correspondant à la valeur Ti, c'est-à-dire Ni = N0*f1/f1i. Par conséquent, la fréquence f3 devient égale à f1i, puisque N0*f1 = f0. Et le comparateur 52 reçoit ainsi les signaux X1 et X3 dont les fréquences valent chacune f1i. Il en résulte que la fréquence f2 est sensiblement égale à la fréquence nominale f0.

Dans l'intervalle de temps compris entre les instants t4 et t5, la température T augmente, et la situation est analogue à celle de l'instant t4, de sorte que la fréquence f2 continue à être égale à la fréquence nominale f0.

Dans l'intervalle de temps compris entre l'instant t5 et un instant t6, la température T diminue. Il s'ensuit, d'après la courbe 23 de la figure 8, que la fréquence f1 fournie par le cristal 51a commence à augmenter. La situation est symétrique de celle de l'instant t4, de sorte que la fréquence f2 continue à être sensiblement égale à la fréquence nominale f0.

Il va de soi pour l'homme de l'art que la description détaillée ci-dessus peut subir diverses modifications sans sortir du cadre de la présente invention. A titre d'exemple, et en se référant à la figure 3, on peut équiper le diviseur 60 d'une mémoire contenant plusieurs valeurs de facteur de division N qui correspondent à plusieurs valeurs de fréquence nominale f0, de sorte que le générateur 50 ainsi équipé peut être utilisé avec plusieurs canaux de transmission.

## Revendications

**1.** Générateur de signal à haute fréquence (50; 76) équipant un système horloger comprenant un cristal (51a) utilisé comme base de temps, ce générateur comprenant :

- un premier oscillateur (51) pour fournir un premier signal (X1) à une première fréquence (f1);
- un deuxième oscillateur (56) pour recevoir une tension de commande (U) et, en réponse, fournir un deuxième signal (X2) à une haute fréquence ou deuxième fréquence (f2) ;
- un premier diviseur (60) pour recevoir ledit deuxième signal, et fournir un troisième signal (X3) à une basse fréquence ou troisième fréquence (f3) égale à ladite deuxième fréquence divisée par un premier facteur de division (N);
- un comparateur de fréquence (52) pour comparer ladite troisième fréquence et ladite première fréquence et, en réponse, fournir des premier et deuxième signaux de commande (DOWN, UP);
- une boucle d'asservissement comprenant un filtre (54) pour recevoir lesdits signaux de commande et, en réponse, fournir ladite tension de commande pour provoquer la fourniture de ladite deuxième fréquence à une fréquence nominale (f0); et
- un moyen de fourniture d'indicateur (58) pour fournir audit filtre (54), en fonction des première et troisième fréquences, un indicateur (LCK) contenant l'état de ladite boucle d'asservissement, ledit filtre comprenant un moyen de commande (64) pour recevoir ledit indicateur (LCK) et, en réponse, fournir un courant de commande (I), de sorte que ledit filtre a une bande passante étroite, respectivement large, quand ladite boucle d'asservissement est, respectivement n'est pas, verrouillée,

ce générateur étant de plus défini en ce que :

- le premier signal est un signal à basse fréquence, et en ce que :

- ledit premier oscillateur comprend le même cristal horloger, propre à fournir le premier signal à basse fréquence, que celui de la base de temps du système horloger.

**2.** Générateur (50; 76) selon la revendication 1, **caractérisé en ce que** ledit moyen de commande (64) est agencé de sorte que ledit courant de commande (I) a une intensité dépendant dudit indicateur (LCK), et un sens d'écoulement dépendant desdits premier et deuxième signaux de commande (DOWN, UP), **et en ce que** ledit filtre (54) est agencé de sorte que la fréquence de coupure dépend dudit courant de commande (I).

**3.** Générateur (50; 76) selon la revendication 1, **caractérisé en ce que** ledit moyen de fourniture d'indicateur (58) est agencé de sorte que ledit indicateur (LCK) est égal à un niveau haut (« 1 »), respectivement à un niveau bas (« 0 »), quand la différence de fréquence (f3-f1) entre lesdites troisième et première fréquences est inférieure, respectivement supérieure, à une valeur prédéterminée $(f1 * \frac{\Delta f}{f})$.

**4.** Générateur (50; 76) selon la revendication 1, **caractérisé en ce que** :

- ledit comparateur de fréquence (52) est agencé de sorte que lesdits premier et deuxième signaux de commande (DOWN, UP) sont égaux respectivement : à un niveau haut (« 1 ») et à un niveau bas (« 0 »), quand ladite troisième fréquence (f3) est sensiblement supérieure à ladite première fréquence (f1); et inversement, quand ladite troisième fréquence (f3) est sensiblement inférieure à ladite première fréquence (f1) ; et **en ce que**
- ledit filtre (54) est agencé de sorte que la valeur efficace (Ieff) dudit courant de commande (I) est égale à : une première valeur élevée positive (+10i) quand lesdits premier et deuxième signaux de commande (DOWN, UP) sont égaux respectivement audit niveau haut (« 1 ») et audit niveau bas (« 0 ») ; et à une deuxième valeur élevée négative (-10i) quand lesdits premier et deuxième signaux de commande sont égales respectivement audit niveau bas (« 0 ») et audit niveau haut (« 1 »).

**5.** Générateur (50; 76) selon la revendication 2, **caractérisé en ce que** ledit filtre (54) comprend un premier condensateur (C2), un deuxième condensateur (C1) et une résistance (R1) agencés pour former un filtre passe-bas (62).

**6.** Générateur (76) selon la revendication 1, **caractérisé en ce qu'**il comprend en outre un dispositif de compensation thermique (77, 78) comprenant :

- un capteur de température (78) disposé à proximité dudit cristal (51a) pour fournir une valeur de mesure (T) de la température ; et
- une première mémoire (77) pouvant contenir une table de correspondance entre des valeurs de température (Ti) et des valeurs de premier facteur de division (Ni), recevoir ladite valeur de mesure (T) et, en réponse, fournir audit premier diviseur (60) la valeur de premier facteur de division (Ni) qui, d'après ladite table de correspondance, correspond à la valeur de température (Ti) la plus proche de ladite valeur de mesure (T).

7. Générateur (76) selon la revendication 6, **caractérisé en ce que** ladite table de correspondance est adaptée à ladite fréquence nominale (f0), et connue à partir d'une calibration dudit cristal (51a).

8. Générateur (76) selon la revendication 6, **caractérisé en ce qu'**il comprend en outre un deuxième diviseur (79) étant connecté entre ledit premier oscillateur (51) et ledit comparateur (52), et pouvant fournir un quatrième signal (X4) à une basse fréquence ou quatrième fréquence (f4), de sorte que cette dernière est égale à ladite première fréquence divisée par un deuxième facteur de division (N2).

9. Générateur (50; 76) selon la revendication 1, **caractérisé en ce que** ledit premier facteur de division (N) dépend de ladite fréquence nominale (f0) et de la température.

10. Générateur (50; 76) selon la revendication 1, **caractérisé en ce qu'**il comprend une deuxième mémoire contenant une pluralité de valeurs de premier facteur de division associées à une pluralité de valeurs de fréquence nominale, et à une valeur de température prédéterminée, de sorte que ledit générateur (50; 76) peut être utilisé avec une pluralité de canaux de transmission associés respectivement à la pluralité de valeurs de fréquence nominale.

11. Générateur (50; 76) selon la revendication 1, **caractérisé en ce que** ledit cristal (51a) est de type CT, et **en ce que** ladite première fréquence (f1) est égale à 32768 Hz.

**Claims**

1. High frequency signal generator (50; 76) fitting a clockwork system including a crystal (51a) used as a time base, this generator including:

   - a first oscillator (51) able to supply a first signal (X1) at a first frequency (f1);
   - a second oscillator (56) able to receive a control voltage (U) and, in response, to supply a second signal (X2) at a high frequency or second frequency (f2);
   - a first divider (60) able to receive said second signal, and to supply a third signal (X3) at a low frequency or third frequency (f3) equal to said second frequency divided by a first division factor (N);
   - a frequency comparator (52) able to compare said third frequency and said first frequency and, in response, to supply first and second control signals (DOWN, UP);
   - a control loop including a filter (54) able to receive said control signals and, in response, to supply said control voltage to cause the supply of said second frequency at a nominal frequency (f0), and
   - indicator supply means (58) able to supply to said filter (54), as a function of said first and third frequencies, an indicator (LCK) containing the state of said control loop, said filter including control means (64) able to receive said indicator (LCK) and, in response, to supply a control current (I), so that said filter has a narrow, or respectively wide band, when said control loop is, or respectively is not, locked, this generator being further defined in that:

   - said first signal is a low frequency signal, and in that:

   - said first oscillator includes the same clockwork crystal, able to supply the first signal at low frequency, as the crystal of the time base of the clockwork system.

2. Generator (50; 76) according to claim 1, **characterised in that** said control means (64) are arranged so that said control current (I) has an intensity dependent on said indicator (LCK), and a direction of flow dependent on said first and second control signals (DOWN, UP), and **in that** said filter (54) is arranged so that the cut-off frequency depends on said control current (I).

3. Generator (50; 76) according to claim 1, **characterised in that** said indicator supply means (58) are arranged so that said indicator (LCK) is equal to a high level (« 1 »), respectively to a low level (« 0 »), when the frequency difference (f3-f1) between said third and first frequencies is less than, or respectively greater than, a predetermined value (f*□ f/f).

4. Generator (50; 76) according to claim 1, **characterised in that**:

   - said frequency comparator (52) is arranged so that said first and second control signals (DOWN, UP) are equal respectively to: a first high level (« 1 ») and a low level (« 0 »), when said third frequency (f3) is substantially greater than said first frequency (f1); and conversely, when said third frequency (f3) is substantially less than said first frequency (f1); and **in that**
   - said filter (54) is arranged so that the efficient value (Ieff) of said control current (I) is equal to: a first positive high value (+10i) when said first and second control signals (DOWN, UP) are equal respectively to said high level (« 1 ») and to said low level (« 0 »); and to a second negative high value (-10i) when said first and second control signals (DOWN, UP) are equal respectively to said low level (« 0 ») and to said high level (« 1 »).

5. Generator (50; 76) according to claim 2, **characterised in that** said filter (54) includes a first capacitor (C2), a second capacitor (C1) and a resistor (R1) arranged to form a low-pass filter (62).

6. Generator (76) according to claim 1, **characterised in that** it further includes a heat compensation device (77, 78) including:

   - a temperature sensor (78) arranged in the vicinity of said crystal (51a) for supplying a measurement value (T) of the temperature; and
   - a first memory (77) able to contain a correspondence table between temperature values (Ti) and first division factor values (Ni), to receive said measurement value (T) and, in response, to supply said first divider (60) with the first division factor value (Ni) which, according to said correspondence table, corresponds to the temperature value (Ti) closest to said measurement value (T).

7. Generator (76) according to claim 6, **characterised in** said correspondence table is adapted to said nominal frequency (f0) and known from calibration of said crystal (51a).

8. Generator (76) according to claim 6, **characterised in that** it further includes a second divider (79) being connected between said first oscillator (51) and said comparator (52), and able to supply a fourth signal (X4) at a low frequency or fourth frequency (f4), so that this latter is equal to said first frequency divided by a second division factor (N2).

9. Generator (50; 76) according to claim 1, **characterised in that** said first division factor (N) depends on said nominal frequency (f0) and on the temperature.

10. Generator (50; 76) according to claim 1, **characterised in that** it includes a second memory containing a plurality of first division factor values associated with a plurality of nominal frequency values, and with a predetermined temperature value, so that said generator (50; 76) can be used with a plurality of transmission channels associated respectively with the plurality of nominal frequency values.

11. Generator (50; 76) according to claim 1, **characterised in that** said crystal (51a) is of the CT type, and **in that** said first frequency (f1) is equal to 32768 Hz.

**Patentansprüche**

1. Hochfrequenztaktgenerator (50; 76) für ein Uhrsystem, das einen Kristall (51a) als Zeitbasis verwendet,
   wobei dieser Generator umfaßt:

   - einen ersten Oszillator (51) zum Liefern eines ersten Signals (X1) mit einer ersten Frequenz (f1);
   - einen zweiten Oszillator (56) zum Empfangen einer Steuerspannung (U) und zum Liefern eines zweiten Signals (X2) mit einer hohen Frequenz oder zweiten Frequenz (f2) in Reaktion darauf;
   - einen ersten Teiler (60) zum Empfangen des zweiten Signals und Liefern eines dritten Signals (X3) mit einer niedrigen Frequenz oder dritten Frequenz (f3), die gleich der zweiten, durch einen ersten Divisionsfaktor (N) geteilten Frequenz ist;
   - einen Frequenzkomparator (52) zum Vergleichen der dritten Frequenz und der ersten Frequenz und, in Reaktion darauf, Liefern von ersten und zweiten Steuersignalen (DOWN, UP);
   - einen Regelkreis mit einem Filter (54) zum Empfangen der Steuersignale und, in Reaktion darauf, Liefern der Steuerspannung zum Bewirken des Erzeugens der zweiten Frequenz bei einer Nennfrequenz (f0);
   - ein Mittel zum Liefern eines Zustandssignals (58), um dem Filter (54) als Funktion der ersten und dritten Frequenz ein Zustandssignal (LCK) bereitzustellen, das den Zustand des Regelkreises enthält, wobei der Filter ein Steuermittel (64) zum Empfangen des Zustandssignals (LCK) und, in Reaktion darauf, zum Liefern eines Steuerstroms (I) derart umfaßt, daß der Filter ein schmales bzw. breites Durchlaßband aufweist, während der Regelkreis verriegelt bzw. nicht verriegelt ist,

   wobei dieser Generator ferner dadurch bestimmt ist, daß:

   - das erste Signal ein Signal mit niedriger Frequenz ist, und daß:
   - der erste Oszillator den gleichen Uhrkristall umfaßt, der zum Liefern des ersten Signals mit niedriger Frequenz geeignet ist wie derjenige der Zeitbasis des Uhrsystems.

2. Generator (50; 76) nach Anspruch 1, **dadurch gekennzeichnet, daß** das Steuermittel (64) derart ausgestaltet ist, daß der Steuerstrom (I) eine Stärke aufweist, die vom Zustandssignal (LCK) abhängig ist, sowie eine Stromflußrichtung, die vom ersten und zweiten Steuersignal (DOWN, UP) abhängt und dadurch, daß das Filter (54) derart ausgestaltet ist, daß die Grenzfrequenz vom Steuerstrom (I) abhängt.

3. Generator (50; 76) nach Anspruch 1, **dadurch gekennzeichnet, daß** das Mittel zum Liefern eines Zustandssignals (58) derart ausgestaltet ist, daß das Zustandssignal (LCK) auf einem hohen Pegel ("1") bzw. auf einem niedrigen Pegel ("0") ist, wenn die Frequenzdifferenz (f3-f1) zwischen der dritten und der ersten Frequenz kleiner bzw. größer als ein vorgegebener Wert (f1*$\Delta$f/f)) ist.

4. Generator (50; 76) nach Anspruch 1, **dadurch gekennzeichnet, daß**:

   - der Frequenzkomparator (52) derart ausgestaltet ist, daß das erste und zweite Steuersignal (DOWN, UP) auf einem hohen Pegel ("1") bzw. auf einem niedrigen Pegel ("0") sind, wenn die dritte Frequenz (f3) im wesentlichen höher ist als die erste Frequenz (f1); und umgekehrt, wenn die dritte Frequenz (f3) im wesentlichen niedriger ist als die erste Frequenz (f1); und daß
   - das Filter (54) so ausgestaltet ist, daß der Effektivwert (Ieff) des Steuerstroms (I) gleich einem ersten erhöhten positiven Wert (+10i) ist, wenn das erste und das zweite Steuersignal (DOWN, UP) gleich dem hohen Pegel ("1") bzw. dem niedrigen Pegel ("0") sind; und gleich einem zweiten negativen erhöhten Wert (-10i) ist, wenn das erste und zweite Steuersignal gleich dem niedrigen Pegel ("0") bzw. dem hohen Pegel ("1") sind.

5. Generator (50; 76) nach Anspruch 2, **dadurch gekennzeichnet, daß** das Filter (54) einen ersten Kondensator (C2), einen zweiten Kondensator (C1) und einen Widerstand (R1) umfaßt, die zum Bilden eines Tiefpaßfilters (62) ausgestaltet sind.

6. Generator (76) nach Anspruch 1, **dadurch gekennzeichnet, daß** er ferner eine thermische Kompensationsvorrichtung (77, 78) umfaßt, die:

   - einen Temperaturfühler (78), der in der Nähe des Kristalles (51) angeordnet ist, um einen Temperaturmeßwert (T) zu erzeugen; und
   - einen ersten Speicher (77) umfaßt, der eine Zuordnungstabelle zwischen den Temperaturwerten (Ti) und den Werten des ersten Divisionsfaktors (Ni) aufweisen, den Meßwert (T) empfangen und in Reaktion darauf dem ersten Teiler (60) den Wert des ersten Divisionsfaktors (Ni) liefern kann, der entsprechend der Zuordnungstabelle dem Temperaturwert (Ti) entspricht, der dem Meßwert (T) am nächsten ist.

7. Generator (76) nach Anspruch 6, **dadurch gekennzeichnet, daß** die Zuordnungstabelle an die Nennfrequenz (f0) angepaßt und aus einer Kalibrierung des Kristalls (51a) bekannt ist.

8. Generator (76) nach Anspruch 6, **dadurch gekennzeichnet, daß** er ferner einen zweiten Teiler (79) umfaßt, der zwischen den ersten Oszillator (51) und den Komparator (52) geschaltet ist, und ein viertes Signal (X4) mit einer niedrigen Frequenz oder vierten Frequenz (f4) derart liefern kann, daß diese vierte gleich der ersten Frequenz dividiert durch einen zweiten Divisionsfaktor (N2) ist.

9. Generator (50; 76) nach Anspruch 1, **dadurch gekennzeichnet, daß** der erste Divisionsfaktor (N) von der Nennfrequenz (f0) und der Temperatur abhängt.

10. Generator (50; 76) nach Anspruch 1, **dadurch gekennzeichnet, daß** er einen zweiten Speicher aufweist, der eine Vielzahl von Werten erster Divisionsfaktoren enthält, die einer Vielzahl von Nennfrequenzwerten und einem vorgegebenen Temperaturwert entsprechen, derart, daß der Generator (50,76) mit einer Vielzahl von Übertragungskanälen verwendbar ist, die entsprechend der Vielzahl der Nennfrequenzwerte zugeordnet sind.

11. Generator (50; 76) nach Anspruch 1, **dadurch gekennzeichnet, daß** der Kristall (51a) vom Typ CT ist, und das die erste Frequenz (f1) gleich 32768 Hz beträgt.

# Fig. 1
(ART ANTERIEUR)

# Fig. 2
(ART ANTERIEUR)

# Fig. 8

Fig. 3

## Fig. 4

54

621    622    544

I    U

644

C2    R1

C1

541

DOWN    641

UP

642    64

542    642

62

643

LCK    543

## Fig. 6

61

$I_{eff}$

+10i

+i

0

$-f1*\frac{\Delta f}{f}$    $+f1*\frac{\Delta f}{f}$    f3-f1(Ln)

-i

-10i

A    C    D    E    B

Fig. 5

Fig. 7

EP 1 006 661 B1

# Fig. 9

# Fig. 10